Europäisches Patentamt

European Patent Office

Office européen des brevets

(19)

(11) **EP 0 717 493 A2**

(12) **EUROPÄISCHE PATENTANMELDUNG**

(43) Veröffentlichungstag:
**19.06.1996  Patentblatt 1996/25**

(51) Int. Cl.[6]: **H03H 17/06**

(21) Anmeldenummer: 95115183.6

(22) Anmeldetag: **27.09.1995**

(84) Benannte Vertragsstaaten:
**CH DE ES FR GB IT LI SE**

(30) Priorität: **16.12.1994 DE 4444870**

(71) Anmelder: **ROBERT BOSCH GMBH**
**70442 Stuttgart (DE)**

(72) Erfinder: **Göckler, Heinz, Dr.**
**D-72522 Backnang (DE)**

(54) **Demodulator für ein komplexwertiges Restseitenbandsignal**

(57)     Bei einem Demodulator für ein komplexwertiges Restseitenbandsignal wird ein aus zwei Teilfiltern (Ra, Ia) bestehendes Nyquistflankenfilter verwendet, dem zur Unterdrückung von Unterträgern eine Filtereinrichtung (FBASTP) nachgeschaltet oder mitintegrierbar ist und zwar so, daß die Realteile (Ra) und Imaginärteile (Ia) der Teilfilter jeweils zusammenfaßbar sind.

Fig. 2

## Beschreibung

Die Erfindung betrifft einen Demodulator für ein komplexwertiges Restseitenbandsignal insbesondere ein Fernsehsignal.

Aus |1| "Digitale Signalverarbeitung - Filterung und Spektralanalyse", K.D. Kammeyer, K. Kroschel, Teubner 1989, Stuttgart, Seiten 122 bis 133, sind Filter für komplexwertige Signale angegeben, die je nach den geforderten Selektionseigenschaften aus Teilfiltern zusammengesetzt sind. Dabei kann eines der Teilfilter einen Hilbert-Transformator darstellen. Die dort vorgestellten Filter lassen sich für beliebige Selektionseigenschaften konzipieren, sind aber sehr aufwendig.

Aus der DE 37 05 206 C2 bzw. DE 37 05 207 C2 |2| sind nichtrekursive Halbbandfilter mit komplexen Koeffizienten zum Verarbeiten eines komplexwertigen Eingangssignal bekannt. Der Aufwand ist dort geringer, aber die Selektionseigenschaften sind nicht frei wählbar.

Aufgabe vorliegender Erfindung ist es, einen Demodulator für ein komplexwertiges Restseitenbandsignal anzugeben, dessen Aufwand relativ niedrig ist und der wählbare Selektionseigenschaften, z.B. zur Abtrennung von Tonträgern, aufweist.

Diese Aufgabe wird durch die Merkmale des Anspruchs 1 gelöst. Die weiteren Ansprüche zeigen vorteilhafte Ausgestaltungen auf.

Der Demodulator nach der Erfindung eignet sich als Restseitenbanddemodulator, insbesondere bei der Demodulation von FBAS-Fernsehsignalen mit gleichzeitiger Abtrennung der Tonträger. Der Demodulator liefert eine Nyquistflanke im gewünschten Bereich und besitzt ausreichende Selektionseigenschaften trotz verringertem Aufwand gegenüber der Realisierung gemäß |1|. Der Demodulator nach der Erfindung gestattet eine einfache Auskopplung von Unterträgern, z.B. Tonträgern, für verschiedenartigste Tondemodulator-Konzepte.

Anhand der Zeichnungen werden Ausführungsbeispiele der Erfindung näher erläutert. Es zeigen

Figur 1 die Frequenzlage eines herabgemischten ZF-FBAS Signals,
Figur 2 ein Blockschaltbild eines Demodulators nach der Erfindung,
Figur 3 eine Blockstruktur zur Umwandlung eines komplexwertigen Signals in ein reellwertiges Signal,
Figur 4 die Übertragungsfunktionen eines aus zwei Teilfiltern zusammengesetzten Nyquistflankenfilters mit Selektionseigenschaften,
Figur 5 die Übertragungsfunktion eines erfindungsgemäßen Demodulator-Filters,
Figur 6 eine Blockstruktur für ein Nyquistflankenfilter nach der Erfindung,
Figur 7 Übertragungsfunktionen eines realisierten Nyquistflankenfilters ohne TT-Falle,
Figur 8 eine realisierte Filterstruktur,
Figur 9 die Frequenzgangkurve zu Figur 8,
Figur 10 eine Tiefpaßstruktur zur Tonunterdrückung,
Figur 11 einen TV-Demodulator mit Tonträgerauskopplung,
Figur 12 Filterstrukturen einer FBAS/TT-Weiche,
Figur 13 eine Blockstruktur eines Nyquistflankenfilters mit Tonträger-Falle,
Figur 14 Übertragungsfunktionen des Filters gemäß Figur 13,
Figur 15 eine von Figur 13 abgeleitete Blockstruktur,
Figur 16 ein Blockschaltbild zur Auskopplung der Tonsignale im komplexwertigen Bereich,
Figur 17 die Teilübertragungsfunktionen zum Konzept nach Figur 16,
Figur 18 den Durchlaßbereich eines Filters zur Tonunterdrückung,
Figur 19 die Koeffizienten des Filters nach Figur 18,
Figur 20 den Frequenzgang eines gemäß Figur 19 aufgebauten Filters,
Figur 21 die Koeffizienten eines modifizierten Filters ,
Figur 22 ein TV-Demodulator-Konzept mit dezimierendem komplexem Nyquistflankenfilter,
Figur 23 das nach $f_{BT}=0$ verschobene ZF-Spektrum,
Figur 24 Strukturblöcke zur Erklärung der Vertauschung von Mischung und Filterung,
Figur 25 den Betragsverlauf eines Gruppenlaufzeitentzerrers und
Figur 26 die entsprechende Laufzeit über der Frequenz.

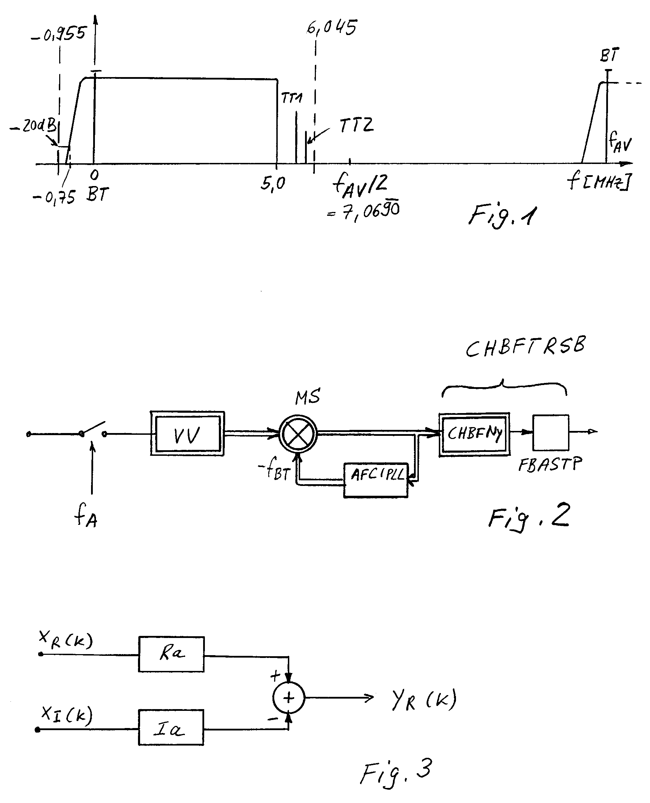

Zur Demodulation von Restseitenbandsignalen, wie beispielsweise Fernsehsignalen in Zwischenfrequenzlage (FBAS-ZF), kann ein Nyquistflankenfilter benutzt werden, wenn die Nyquistfrequenz (6dB-Punkt der Symmetrie) exakt bei der Trägerfrequenz liegt. Ein FBAS-ZF Signal stellt im Prinzip ein AM-Signal dar, bei dem ein Seitenband bis auf 750 kHz beim Bildträger BT unterdrückt wurde. Figur 1 zeigt die Lage eines solchen Signals im Frequenzraster, wobei durch Digitalisierung (Abtastung) dieses Signals ein sich wiederholendes Spektrum entsteht (1. Wiederholung bei der Abtastfrequenz $f_{AV}$). Die im FBAS-Signal enthaltenen Tonträger sind mit TT1 und TT2 bezeichnet, so daß das zu verarbeitende Signal vereinfacht als $FBAS_{TT}$-Signal bezeichnet wird. Am Eingang des in Figur 2 dargestellten Demodulators

2

befindet sich eine Mischstufe MS, die ein komplexwertiges Digitalsignal mit dem aktuellen Wert der Bildträgerfrequenz $f_{BT}$ nach f=0 mischt. Damit ist die Nyquistfrequenz des komplexen Nyquistflankenfilters $f_{NY} = 0$ mit einer Breite des Flankenbereichs von BF = 2 x 750 kHz = 1,5 MHz. Da das Nyquistflankenfilter als komplexes Halbbandfilter realisierbar ist, wird es nachfolgend mit CHBF Ny bezeichnet (DE 37 05 206 C2).

Zur Gewinnung eines komplexwertigen Digitalsignals (komplexwertige Digitalsignale sind in den Zeichnungen durch Doppelstriche symbolisiert) aus dem abgetasteten reellen ZF-FBAS Signal ist eine vorverarbeitungsstufe VV (komplexe Filterstufe) vorgesehen, die ausführlich in der deutschen Patentanmeldung P 44 17 723.2 beschrieben ist.

Der RSB (Restseitenband)-Demodulator CHBFRSB ist mittels des Nyquistflankenfilters CHBF Ny realisierbar, dem nach der Ausgestaltung gemäß Figur 2 ein Tiefpaß FBASTP zur Unterdrückung bzw. Abtrennung der Tonsignale TT nachgeschaltet ist. Vom Ausgangssignal des Nyquistflankenfilters CHBF Ny wird nur der Realteil oder der Imaginärteil an den Tiefpaß FBASTP weitergereicht, da der Bereich $[f_{AV}/2, f_{AV}]$ keine störenden Spektralanteile (Figur 1) enthält.

Zum weiteren Verständnis der Erfindung werden nun einige Grundlagen für Filter mit komplexwertigen Koeffizienten angegeben. h(z) stellt die Übertragungsfunktion eines Filters mit komplexen Koeffizienten dar entsprechend der komplexen Impulsantwort h(k).

$$H(z) \;\bullet\!\!-\!\!-\!\!-\!\!-\!\!\circ\; \underline{h}(k) \;=\; \underline{h}(kT)$$

$$\text{mit } z = e^{j\Omega} = e^{j2\pi f/f_A}$$

wobei $f_A = 1/T$ die Abtastfrequenz darstellt.

h(k) läßt sich in einen Realteil $h_R(k)$ und einen Imaginärteil $h_I(k)$ zerlegen gemäß:

$$\underline{h}(k) = h_R(k) + jh_I(k)$$

und gemäß |1|:

$$Ra[\underline{H}(e^{i\Omega})] = \frac{1}{2}[\underline{H}(e^{i\Omega}) + \underline{H}^*(e^{-i\Omega})] \;\bullet\!\!-\!\!-\!\!\circ\; h_R(k)$$

$$Ia[\underline{H}(e^{i\Omega})] = \frac{1}{2j}[\underline{H}(e^{i\Omega}) - \underline{H}^*(e^{-j\Omega})] \;\bullet\!\!-\!\!-\!\!\circ\; j_I(k)$$

Aus diesen beiden Beziehungen ergibt sich, daß

a) eine exakte Nyquistflanke realisierbar ist und
b) der Realteil Ra ein allgemeines Selektionsfilter (Tiefpaß/Bandpaß) und
c) der Imaginärteil Ia ein Hilberttransformator HT ebenfalls mit Selektionseigenschaften sein muß.

Bei der Verwendung nichtrekursiver (FIR)-Filter weist Ra im allgemeinen positive symmetrische Koeffizienten und Ia negative symmetrische Koeffizienten auf.

Figur 3 zeigt als Beispiel ein Filter zu Umwandlung eines komplexwertigen Signals ($x_R(k)$, $x_I(k)$) in ein reellwertiges Signal $y_R(k)$. Beide Teilfilter Ra und Ia sind gleich aufwendig.

Figur 4 zeigt die Übertragungsfunktionen dieser beiden Teilfilter und des Gesamtfilters $\underline{H}(e^{i\Omega})$. Nach |2| ist fg = $f_A/2$ fest vorgegeben, weshalb die Selektionseigenschaften von $\underline{H}(e^{j\Omega})$ nicht veränderbar sind. Die Konsequenz daraus ist, daß:

Ra eine Konstante $h_o$ ist, also ein Filter mit nur einem Koeffizienten. Im kausalen realisierbaren Fall wird diese Konstante kombiniert mit einer Verzögerung $\frac{N-1}{2}T$, wenn N die Filterlänge ist (FIR-Realisierung). Ia ist ein konventioneller Hilbert-Transformator ohne Selektionseigenschaften.

Gegenüber der Realisierung nach |1| ist die Zahl der Multiplikationen etwa halbiert; der Nachteil liegt darin, daß die Selektionseigenschaften festgelegt und nicht frei wählbar sind.

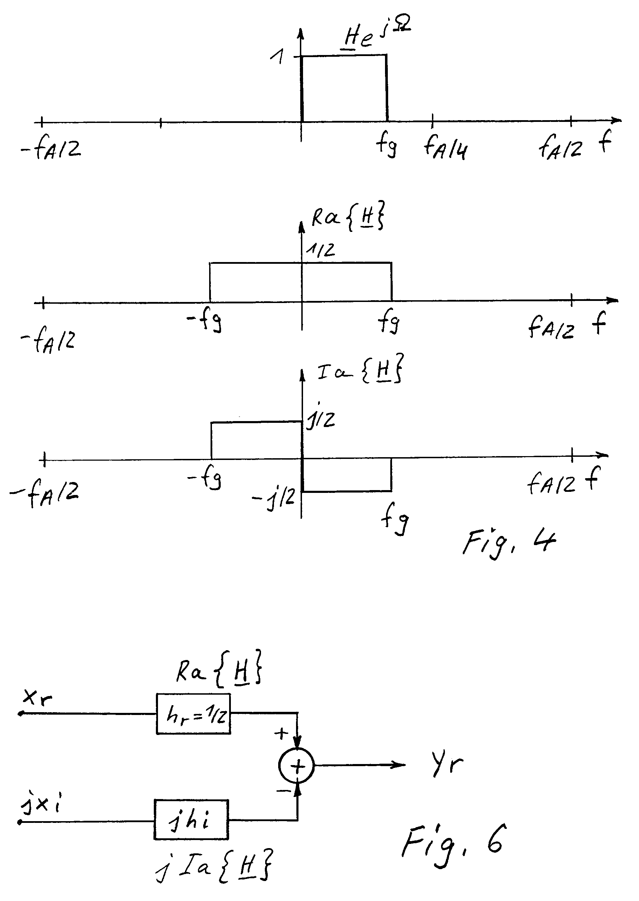

Nachfolgend wird nun ein Filter vorgestellt, welches erfindungsgemäß die gewünschte Nyquistflanke aufweist, mit gewissen Einschränkungen frei wählbare Selektionseigenschaften aufweist und dessen Aufwand, insbesondere hinsichtlich der Zahl der Multiplikationen in der Filterkette, ähnlich wie bei |2| sein soll (Ra hat nur ein Filterkoeffizient). Die Übertragungsfunktion für das erfindungsgemäße Demodulator-Filter ergibt sich aus Figur 5. Es setzt sich aus den beiden Teilübertragungsfunktionen Ra und la zusammen. la hat im Bereich [-$f_A$/2, +$f_A$/2] den konstanten Betrag $h_o$ = 1/2 . la ist punktsymmetrisch zu f = 0. Seine Übertragungsfunktion wechselt zwischen j/2 und -j/2. Es ist ein verallgemeinerter Hilbert-Transformator, der zwischen jeweils zwei unterschiedlichen Bereichen (Durchlaß- bzw. Sperrbereichen) eine einfache (allgemein eine ungeradzahlige Anzahl) von Nullstellen aufweist.

Während es bei den Realisierungen gemäß |1| und |2| stets möglich ist, das komplexe Nyquistflankenfilter von einem Prototypen mit reellen Koeffizienten abzuleiten, ist dies bei der erfindungsgemäßen Lösung ausgeschlossen. Der durch Figur 5 charakterisierte Frequenzgang ist für einen TV-RSB-Demodulator ausreichend, insbesondere hinsichtlich der geforderten Selektionseigenschaften. Die Haupteigenschaften des erfindungsgemäßen Demodulator-Filters seien nochmals kurz zusammengefaßt:

- Ra weist eine ungerade Anzahl von Koeffizienten $h(_k)$ auf, die der Bedingung

$$h(_k) = h(-_k)$$

genügen. Gemäß der Realisierung nach Figur 5 besonders vorteilhaft:
- nur ein Koeffizient,
- für einen bestimmten Parameter k ist ein Koeffizient entweder rein reell oder rein imaginär,
- la ist Hilbert-Transformator mit einer ungeraden Anzahl von Koeffizienten, für die gilt:

$$h(-k) = -h(k),$$

- Verknüpfung von Ra und la derart, daß mindestens ein Durchlaß- und ein Sperrbereich entsteht.

Für Nyquistflanken, die nicht bei f=0 liegen, ergeben sich folgende Beziehungen

a) Nyquistflanke bei $f_A$/2:

$$\underline{h}'(k) = (-1)^k \underline{h}(k)$$

b) Nyquistflanke bei $f_A$/4 bzw. 3$f_A$/4:

$$\underline{h}''(k) = (\pm j)^k \underline{h}(k).$$

Für b) sind die Koeffizienten abwechselnd reell oder imaginär; der Multiplikationsaufwand ist wie bei der Struktur nach Figur 3 nur gleichmäßig auf beide Teilfilter verteilt.

Das Nyquistflankenfilter CHBF Ny nach der Erfindung besitzt vorteilhafterweise die Struktur nach Figur 6:

$$Ra \{H\} \rightarrow hr = 1/2$$

$$jla \{H\} \rightarrow jhi .$$

Zur Spezifikation eines solchen Filters gelten folgende Werte:
$f_A$ = 14,138$\overline{18}$ MHz
$f_f$ = 750 kHz (Flankenbereich)
$f_d$ = $f_A$/2 - $f_f$ = 6,31$\overline{90}$ MHz
Durchlaßbereich:
$f_f$ ... $f_d$ mit Durchlaßbereichsripple von $\Delta a_{pp} \leq 0{,}1$ dB.

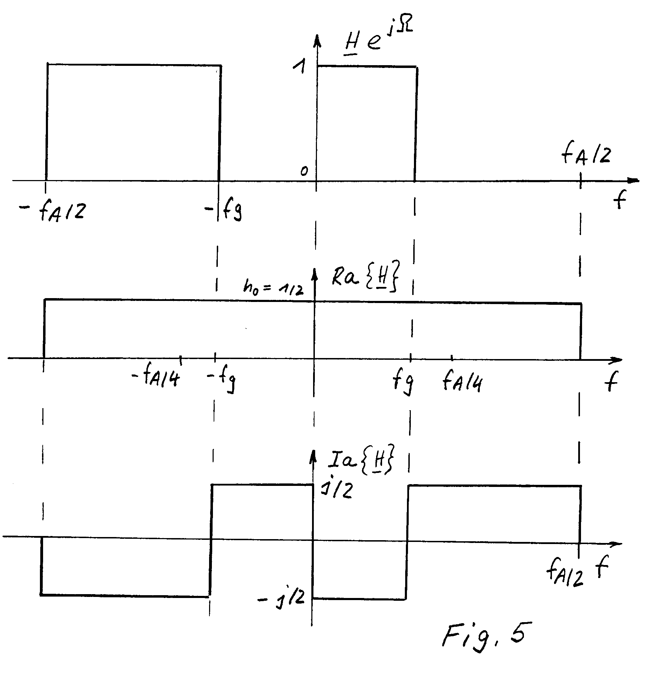

Wie aus Figur 7 ersichtlich ist, läßt sich der Durchlaßbereich am oberen (nicht definierten) Ende so vorgeben, daß das Nyquistflankenfilter ein komplexes Halbbandfilter CHBF wird:

$$f_d \, CHBF = f_d - f_A/4 = 2{,}7845 \, MHz.$$

Mit einer Filterlänge von N = 19 wird $\Delta a_{pp}$ = 0,16 dB erreicht, was für die Anwendung als TV-Demodulator ausreichend ist.

Die Multiplikationsrate (mittlerer Koeffizient $h_r$ = 1/2 mitgerechnet) aber ohne Nutzung der Symmetrie ergibt sich zu:

$$M_A{}^{Ny} = (1 + \frac{N+1}{2})\, f_A = 11\, f_A.$$

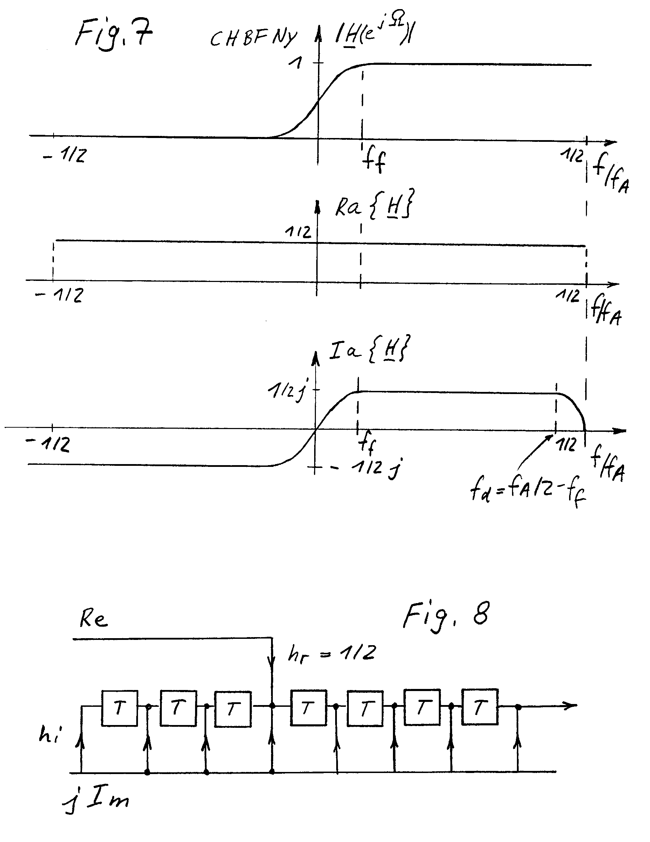

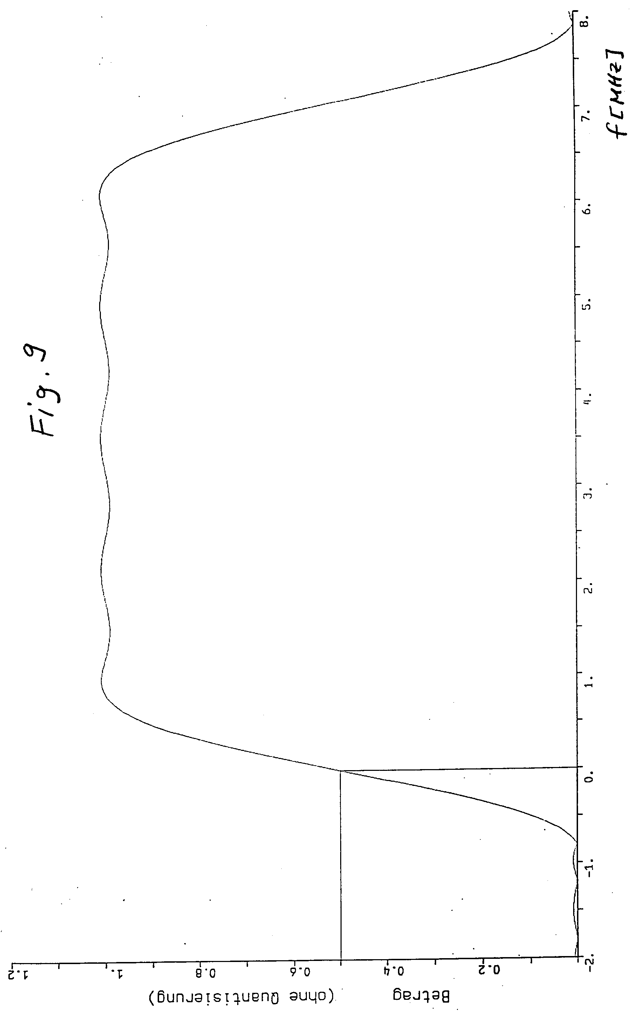

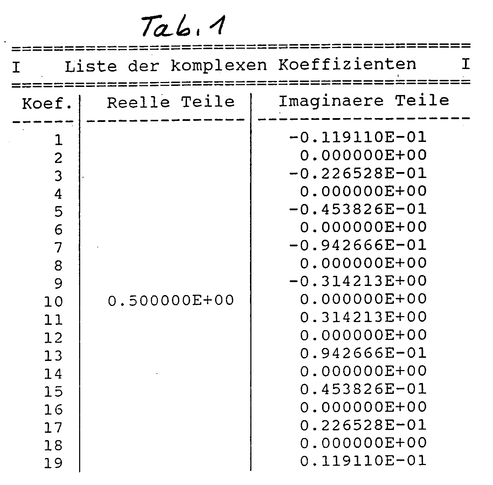

Die realisierte Filterstruktur - nichtrekursives Transversalfilter - ist in Figur 8 dargestellt mit zugehöriger Frequenzgangkurve (Betrag) in Figur 9. Die $h_i$ Koeffizienten sind aus Tabelle 1 zu entnehmen.

Für den nachgeschalteten Tiefpaß FBASTP zur Unterdrückung der Tonträger TT - Tonfalle - gilt folgende Spezifikation:

$f_A = 14,13818$ MHz,

Durchlaßbereich: 0 ... 4,9 MHz,

fd = 4,9 MHz,

$\Delta a_{pp} \leq 0,1$ dB,

Sperrbereich 1: $f_{sp1} ... f_{sp2}$: 5,42 ... 5,83 MHz

$a_s \geq 50$ dB

Sperrbereich 2 (zur Vermeidung ungewollter Verstärkungen):

$f_{sp2} ... f_A/2$ , $a_s \geq 6$ dB

Mit einer Filterlänge N=63 ergibt sich $\Delta a_{pp} \approx 0,0$ dB

$a_s = 51$ dB.

Multiplikationsrate:

$$M_A{}^{TF} = N \cdot f_A = 63\, f_A$$

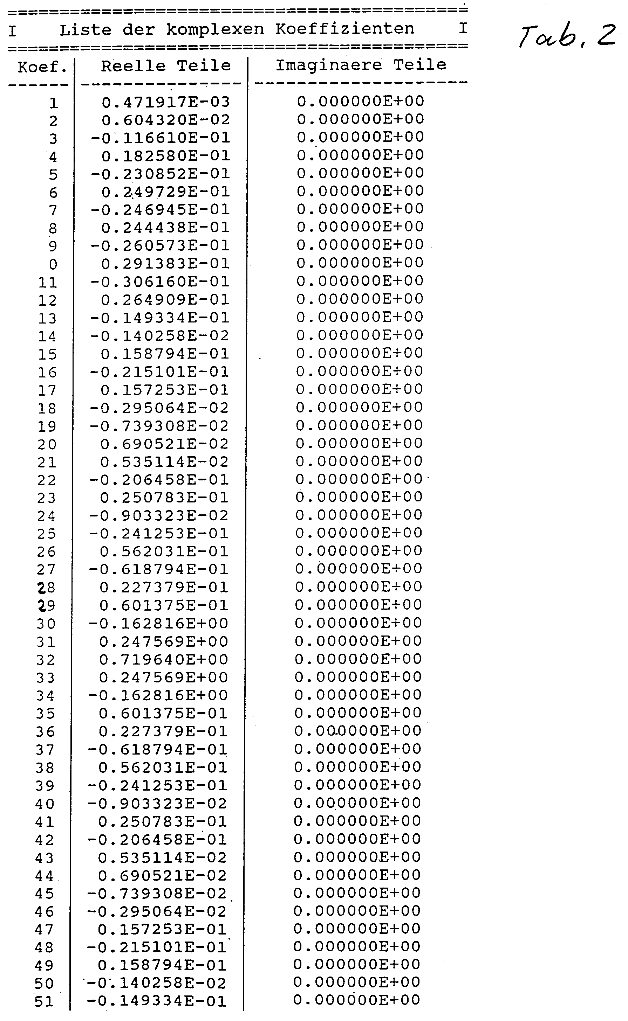

Der Tiefpaß FBASTP kann beispielsweise aus einer einfachen Transversalfilterstruktur nach Figur 10 mit einem Eingang für die Realteile des Nyquistflankenfilters CHBF Ny bestehen. Seine Koeffizienten zeigt Tabelle 2. Für das Gesamtfilter CHBFTRSB ergibt sich demnach:

$$M_A = M_A{}^{Ny} + M_A{}^{TP} = 74\, f_A.$$

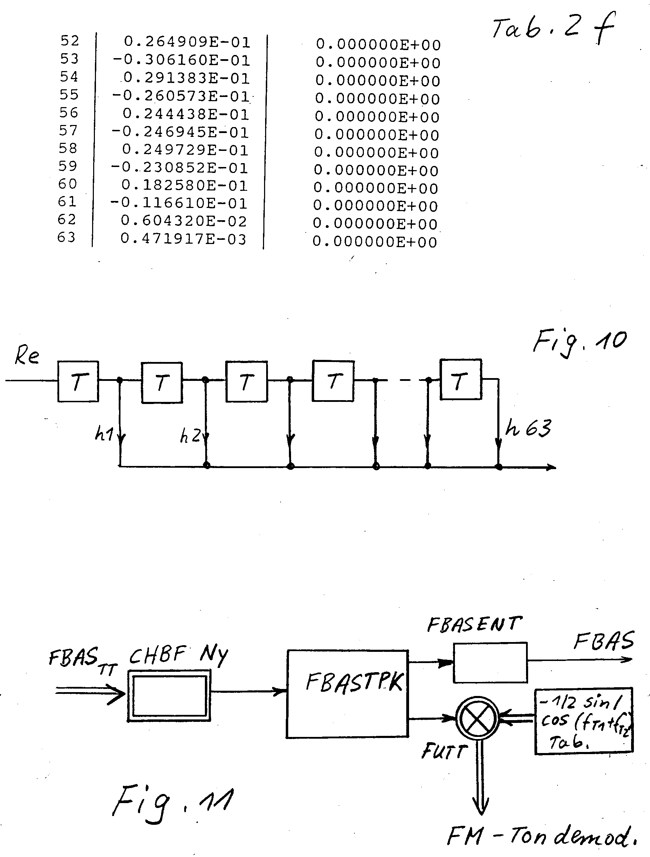

In einer Erweiterung kann der Tiefpaß FBASTP nicht nur als Tonträgerfalle ausgebildet sein, sondern einen weiteren Ausgang aufweisen (Tonweiche) zur Auskopplung des/der Tonträger/s aus dem TV-Demodulator (Figur 11). Die beiden Tonträger TT liegen als reelles Signal bei ca. 5,625 MHz, also recht weit ab von $f_A/4$. Wenn die Ton-FM-Demodulation mit einer komplexen Trägerschwingung erfolgen soll, die vom Bilddemodulator abgeleitet ist (z.B. bei der P 44 17 723.2 oder der P 44 17 724.0), wird die Umwandlung der reellen Tonträger ins Komplexe günstigerweise mit der Weaver-Methode durchgeführt.

Für die Erweiterung des Tiefpaßes gemäß Figur 11 wird eine komplementäre Filterstruktur FBASTPK verwendet, deren Filterlänge N gegenüber der vorherigen Lösung nicht erhöht werden soll.

Wenn

$$H_{(z)} = \sum_{n=1}^{N} h_{(k)}\, z^{-n}$$

die Übertragungsfunktion der Tonfalle FBASTP gemäß Figur 10 darstellt, ergibt sich die dazu komplementäre Übertragungsfunktion

$$Hc\ (z)\ =\ \pm\ (z^{-\frac{N+1}{2}}\ -\ H(z))$$

$$=\ \pm\ \sum_{n=1}^{N}\ h'_n\ z^{-n}$$

$$Mit\ h_n\ =\ h_n\ \forall\ n\ \neq\ \frac{N+1}{2}$$

$$h'_{\frac{N+1}{2}}\ =\ 1\ -\ h_{\frac{N+1}{2}}$$

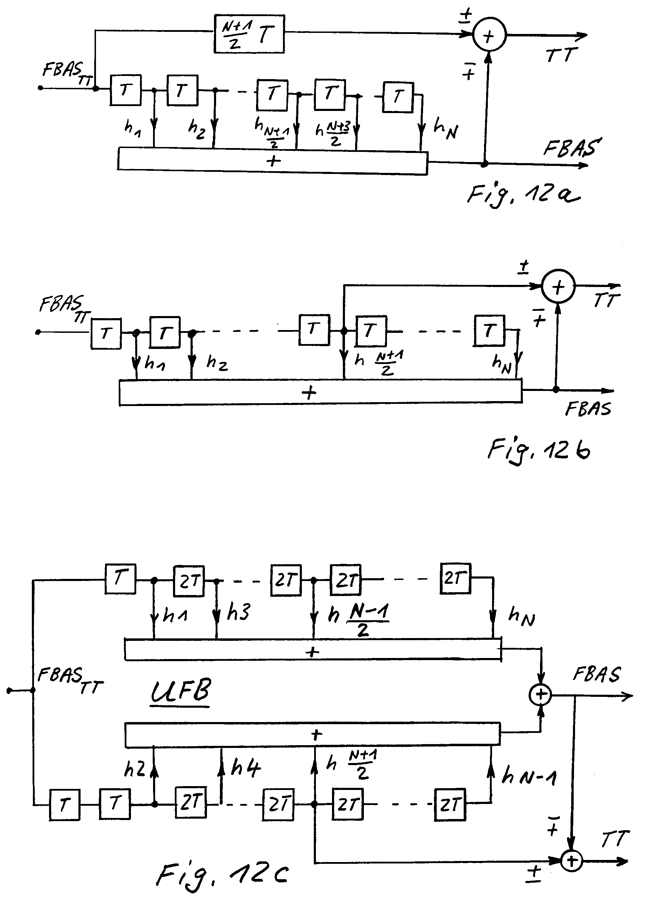

Verschiedene Realisierungsmöglichkeiten hierfür sind in Figur 12a bis c dargestellt. Es kann vorteilhaft der in der DE 43 05 075 C1 aufgezeigte Universalfilterbaustein UFB hierzu verwendet werden.

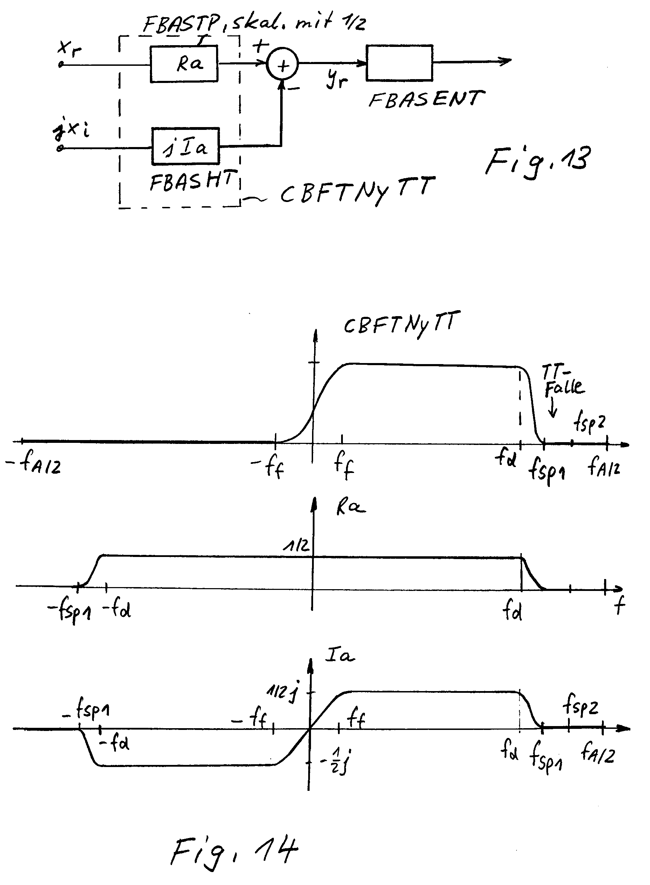

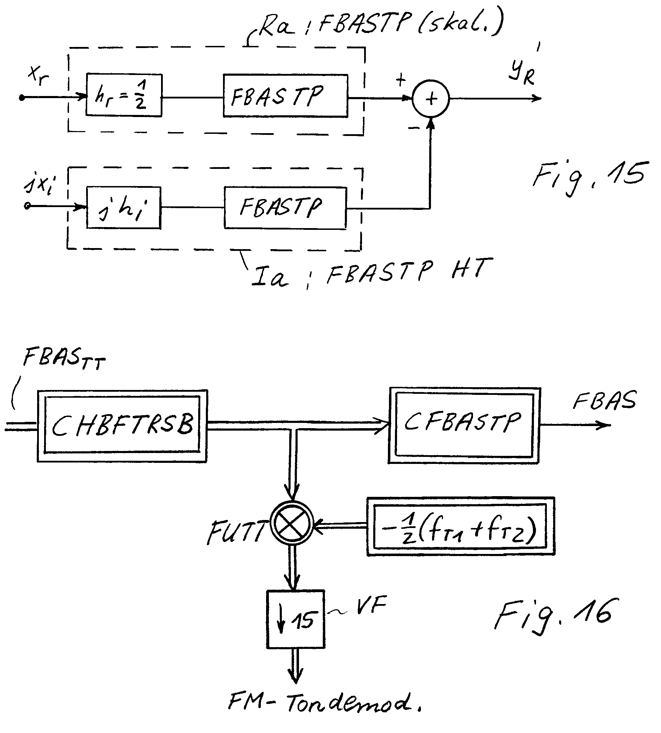

Eine weitere Ausgestaltung des Restseitenbanddemodulators nach der Erfindung ergibt sich durch die Kombination der Nyquistflankenfilterung und der Tonträger-Falle in einem Filter. Die Struktur dieses Filters zeigt Figur 13. Das Gesamtfilter ist mit CBFT Ny TT bezeichnet. Die zugehörigen Übertragungsfunktionen der Teilfilter Ra und jla sind in Figur 14 dargestellt. Wie zuvor sind die Filterflanken, Sperr- und Durchlaßbereiche mit $f_f$, $f_d$ und $f_{sp}$ gekennzeichnet. Wie aus Figur 4 und Figur 14 ersichtlich ist, stellt der Ra-Zweig die mit dem Faktor 1/2 skalierte Variante des Filters FBASTP von Figur 2 dar. Die Struktur von Figur 15 zeigt dies noch anschaulicher. Im la-Zweig realisiert jh$_i$' den Frequenzgang - Hilbert-Transformator HT von Figur 7 - und das Filter FBASTP bewirkt die Bandbegrenzung am oberen Bandende. Beide kaskadierten Übertragungsfunktionen lassen sich zu einem einzigen Hilbert-Transformator HT zusammenfassen, dessen obere Bandbegrenzung entsprechend Ra und dessen Nyquistflanke entsprechend la spezifiziert ist. Da der so geforderte Frequenzgang im Gegensatz zu Figur 7 nicht symmetrisch zu $f_A/4$ ist, sind alle bis auf den mittleren Koeffizienten des Hilbert-Transformators HT ungleich Null. Die Filterlänge N ist bestimmt durch den steileren Übergangsbereich für die Tonfalle an der oberen Bandkante. Damit folgt unmittelbar, daß Ra und la(HT) die gleiche Filterlänge N=63 (FBASTP) erfordern. Damit ergibt sich für die Multiplikationsrate:

$$M_C\ =\ \underbrace{N\ \cdot\ f_A}_{Ra}+\ \underbrace{(N-1)\ f_A}_{Ia}\ =$$

$$=\ (2N-1)\ f_A\ =\ 125\ f_A.$$

Um Überhöhungen im Nyquistflankenbereich zu verringern wird der Flankenbereich $f_f \leq 750$ kHz gewählt. Die zuletzt vorgestellte Lösung mit dem Gesamtfilter CBFT Ny TT ist aufwendiger als die zuvor beschriebenen Konzepte. Außerdem ergeben sich für die FM-Tonverarbeitung keine Zusatzvorteile.

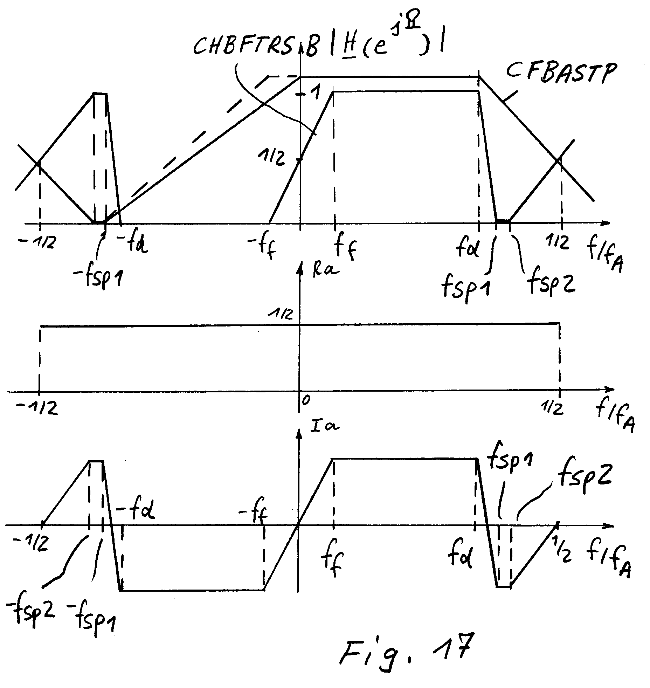

Eine weitere Ausgestaltung der Erfindung nach Figur 16 greift die Realisierung gemäß Figur 6 nochmals auf. Der Filterbaustein CHBFTRSB liefert ein komplexwertiges Ausgangssignal, das einer Tonfalle CFBASTP für komplexwertige Eingangssignale zugeführt wird. Das komplexwertige Ausgangssignal des Filterbausteins CHBFTRSB wird direkt einer Mischstufe FUTT zugeführt, die das komplexwertige Signal mit einer Frequenz -1/2 ($f_{T1}$ + $f_{T2}$) umsetzt. Nach einer Dezimation (Abtastratenwandlung) in einer Videofalle VF z.B. um den Faktor 15 kann dieses Signal als Mischsignal im FM-Tondemodulator beispielsweise gemäß P 44 17 724.0 verwendet werden. Die Teilübertragungsfunktionen des CHBFTRSB und des CFBASTP zeigt Figur 17. Von allen bisher vorgestellten Konzepten ist hier der Aufwand bei der FM-Demodulation am meisten verringert. Die Multiplikationsrate für dieses Konzept beträgt:

$$M^{RSB} = 2N \cdot f_A = 126\, f_A.$$

Für eine aufwandsgünstige Realisierung des Filters CFBASTP kann die Tatsache ausgenutzt werden, daß nur ein reelles Signal (Re) abgegeben werden muß. Für den Durchlaßbereich ist eine Ausdehnung bis -750 kHz - entsprechend $f_f$ - nicht notwendig (gestrichelter Verlauf in Figur 17), so daß man die Durchlaßkante auf die Bildträgerfrequenz f = 0 legen kann.

Zwei unterschiedliche Möglichkeiten zur Ableitung des Filters CFBASTP von einem reellen Prototypfilter werden nun vorgestellt. Im ersten Fall I ist der Prototyp ein reelles Halbbandfilter HBF. Im zweiten Fall II ist der Prototyp ein reeller Tiefpaß, der den Übergangsbereich optimal breit läßt.

Die Mittenfrequenz des Durchlaßbereichs von CFBASTP liegt bei

$$fm = 1/2 \cdot 4,9\ \text{MHz} = 2,45\ \text{MHz}.$$

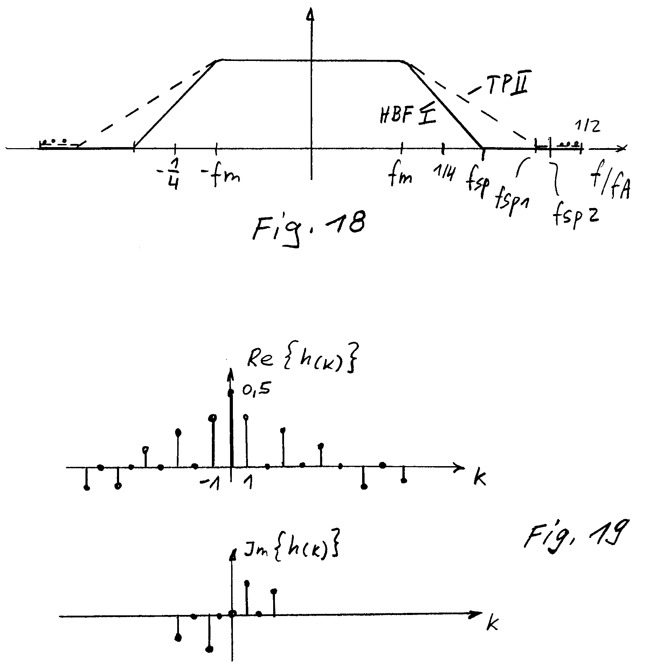

Verschiebt man den Frequenzgang um $-f_m$, so liegt der ursprünglich bei $f_m$ zentrierte Durchlaßbereich bei f = 0 (Figur 18). Durch entsprechende Verschiebung der Sperrbereichskanten $f_{sp}$ wird ein gewünschter Sperrbereich von 5,8581 ... 6,2681 MHz erreicht.

Mit $f_A$ = 14,13818 MHz
  $f_d$ = fm = 2,45 MHz
  und $a_s$ = 50 dB
ergibt sich:
  N = 19 (Filterlänge)
  $\Delta a_{pp}$ = 0,03 dB

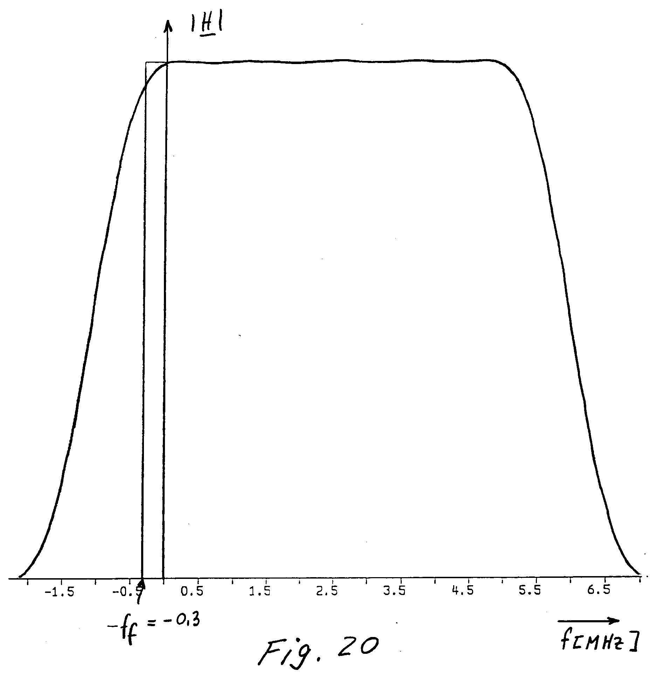

Figur 19 zeigt die Koeffizienten des Filters CFBASTP bzw. Re {h(k)} und Im {h(k)} und Figur 20 den Frequenzgang dieses Filters. Mit etwas geringeren Forderungen hinsichtlich Welligkeit und Sperrdämpfung läßt sich der Filteraufwand auf N = 11 reduzieren.

Für die Ableitung des Filters CFBASTP nach Fall II ergeben sich mit ähnlichen Voraussetzungen die Filterkoeffizienten gemäß Figur 21.

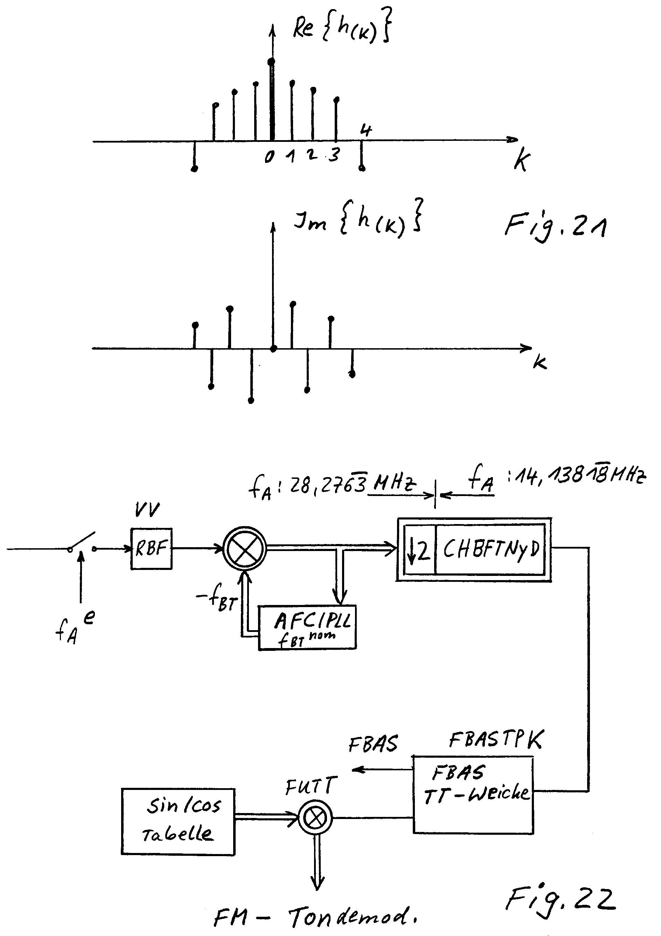

Ein weiteres Konzept eines erfindungsgemäßen TV-Demodulators nach der Erfindung zeigt Figur 22. Hier wird die Reihenfolge der Filterung und Frequenzregelung (bzw. Mischung) AFC/PLL auf den Bildträger $f_{BT}^{nom}$ = 17,6527 MHz vertauscht. Das komplexe Nyquistflankenfilter ist in diesem Falle dezimierend - CHBFT Ny D - ausgebildet, d.h. es wird mit intern verminderter Abtastfrequenz gearbeitet:

14,13818 MHz statt $f_A$ = 28,27$\overline{63}$ MHz bei der Abtastung des ZF-Signals. Der Dezimationsfaktor - hier 2 - entspricht jenem Faktor um den das komplexwertige Fernsehsignal zuvor überabgetastet wurde. Für das dezimierende komplexe Nyquistflankenfilter CHBFT Ny D wird vorausgesetzt, daß die AFC-PLL-Schleife korrekt eingerastet ist entsprechend einer Bildträgerfrequenz $f_{BT}$ = 0 Hz.

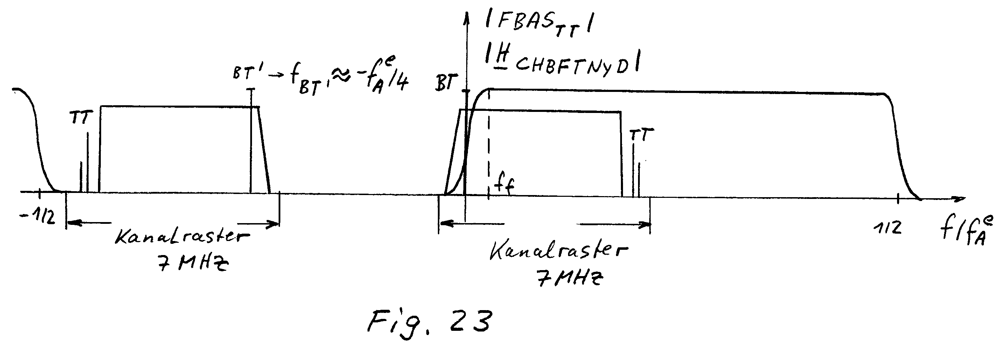

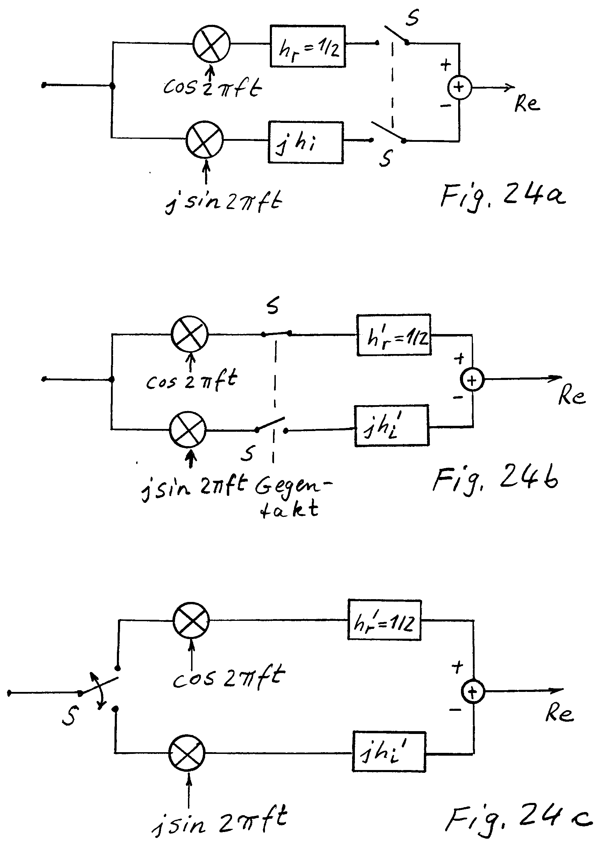

Das nach $f_{BT}$ = 0 verschobene ZF-Spektrum ist in Figur 23 dargestellt. Durch die breiten Lücken zwischen Nutz- und Spiegelspektrum, liegt das Spiegelspektrum vollständig im Sperrbereich. Die Filterlänge kann bei einer HBF-Prototyp-Realisierung zu N = 75 angesetzt werden, wobei vorausgesetzt wurde, daß alle Multiplikationen bei der halbierten Ausgangsabtastfrequenz durchgeführt wurden. Zur Verdeutlichung des Prinzips der Vertauschung von Mischung und Filterung dienen die Strukturblöcke nach Figur 24a bis c. Die komplexe Mischung ist durch die beiden Trägerschwingungen $\cos 2\pi\,ft$ und $j \sin 2\pi\,ft$ angedeutet. Im Ra-Zweig ist wie zuvor nur der Koeffizient $h_r$ = 1/2 vorhanden und im Ia-Zweig gilt: jhi', wobei genau jeder 2. Koeffizient identisch Null ist. Die Dezimation ist in Figur 24a schematisch durch die beiden Abtaster S hinter den Filterzweigen dargestellt.

Im Fall 24b wurden die Abtaster S vor die Filterzweige gezogen, die im Gegentakt gesteuert werden. Die Verzögerungsketten der Filterzweige mit den Koeffizienten $h_r$ = 1/2 und jhi' weisen nun jeweils halbe Länge auf unter Wegfall der Nullkoeffizienten.

Schließlich sind in Figur 24c die Schalter S zu einem Mittelpunktschalter vor den Mischeinrichtungen vereinigt; d.h. die Dezimation ist in Figur 24c vor die Mischung gezogen, was die Multiplikationsrate um 2 vermindert. Letztere Lösung hat auch den Vorteil einer einfacheren Ausgestaltung der AFC/PLL-Schleife (sin/cos Tabelle). Auch für das Konzept nach Figur 22 kann der zuvor erwähnte UFB-Baustein eingesetzt werden.

Für den vorgestellten TV-Demodulator ist gegebenenfalls ein Gruppenlaufzeitentzerrer FBASEBT notwendig, der der Tonfalle FBAST, der Tonweiche FBASTPK bzw. dem Kombinationsfilter CHBFT Ny TT nachgeschaltet wird. Dieser Gruppenlaufzeitentzerrer soll einen möglichst konstanten Betragsverlauf haben, aber einen nichtlinearen Phasenverlauf. Vorzugsweise besteht der Gruppenlaufzeitentzerrer FBASENT aus zwei FIR-Filterblöcken F1 und F2, wobei hg eine gerade Impulsantwort und hu eine ungerade Impulsantwort besitzt. Das Teilfilter F1 besitzt positiv symmetrische Koeffizienten $h_og(_k)$ und das Teilfilter F2 negativ symmetrische Koeffizienten $h_ou(_k)$.

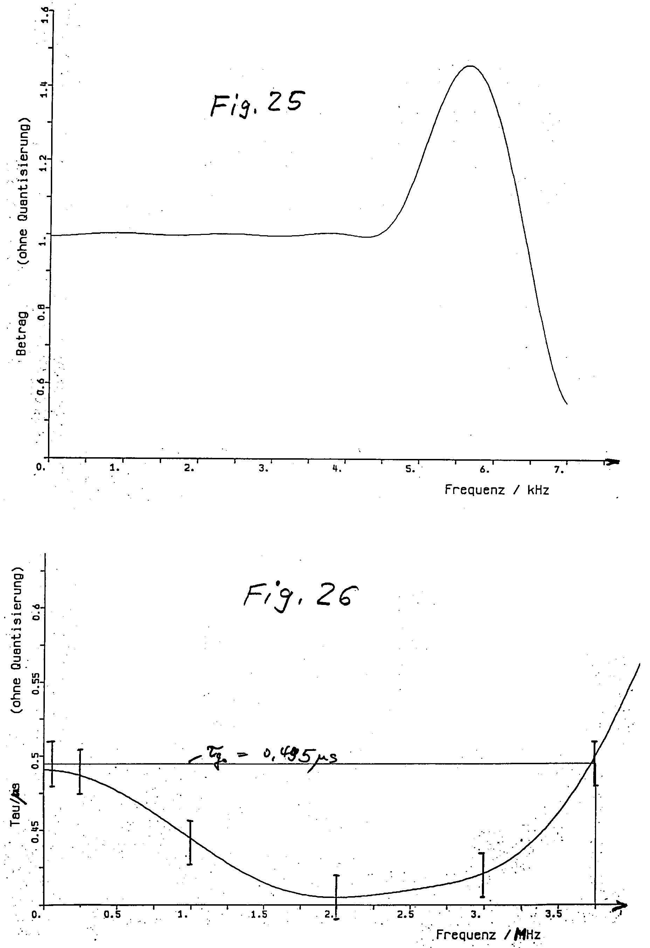

Die Filterlänge ist für den geraden Anteil N = 14 und für den ungeraden Anteil N = 15. Figur 25 zeigt für einen realisierten Gruppenlaufzeitentzerrer den Betrag und Figur 26 die Laufzeit $\tau$g über der Frequenz.

## Patentansprüche

1.  Demodulator für ein komplexwertiges Restseitenbandsignal, insbesondere Fernsehsignal, bestehend aus:

    -   einem digitalen Nyquistflankenfilter (CHBFNy) mit komplexen Koeffizienten $\underline{h}_{(k)}$, wobei k ganzzahlig ist, mit folgender Struktur:
    -   das Nyquistflankenfilter besteht aus zwei Teilfiltern (Ra Ia),
    -   das erste Teilfilter (Ra) weist eine ungerade Anzahl von Koeffizienten h(k) auf, die folgender Bedingung genügen:

    $$h_{(k)} = h_{(-k)},$$

    -   das zweite Teilfilter (Ia) stellt einen Hilbert-Transformator dar mit einer ungeraden Anzahl von Koeffizienten $h_{(k)}$ für die gilt:

    $$h_{(-k)} = -h_{(k)},$$

    -   für einen bestimmten Parameter k ist ein Koeffizient $h_{(k)}$ des Nyquistflankenfilter entweder rein reell oder rein imaginär,
    -   die Teilfilter (Ra, Ia) sind miteinander ausgangsseitig additiv oder subtraktiv so verknüpft, daß durch die Kombination ihrer Übertragungsfunktionen mindestens ein Durchlaß- und ein Sperrbereich entsteht,
    -   einer digitalen Filtereinrichtung (FBASTP) mit reellen Koeffizienten zur Unterdrückung von mindestens einem Unterträger, z.B. einem Tonträger, im Restseitenbandsignal/Fernsehsignal, welche dem Nyquistflankenfilter (CHBFNy) nachgeschaltet ist oder mit diesem zusammen in einer Filtereinrichtung integriert ist, wobei jeweils die Übertragungsfunktionen der Teilfilter (Ra, Ia) für Realteil und Imaginärteil bezüglich digitaler Filtereinrichtung (FBASTP) und Nyquistflankenfilter (CHBFNy) zusammengefaßt sind.

2.  Demodulator nach Anspruch 1, dadurch gekennzeichnet, daß das erste Teilfilter (Ra) rein reelle ($h_{r(k)}$) Koeffizienten aufweist und daß das zweite Teilfilter (Ia) eine ungerade Anzahl von rein imaginären Filterkoeffizienten ($h_{i(k)}$) aufweist, die symmetrisch zum mittleren Koeffizienten sind, insbesondere den gleichen Betrag aufweisen und sich nur im Vorzeichen unterscheiden, wobei der mittlere Koeffizient gleich 0 ist.

3.  Demodulator nach Anspruch 2, dadurch gekennzeichnet, daß das erste Teilfilter (Ra) nur einen Koeffizienten aufweist, wobei gilt:

    $$h_{r(k)} = 1/2$$

    und daß das zweite Teilfilter (Ia) den mittleren Koeffizienten 0 aufweist.

4.  Demodulator nach einem der Ansprüche 1 bis 3. dadurch gekennzeichnet, daß das Nyquistflankenfilter als dezimierendes Filter (CHBFTNyD) ausgebildet ist.

5.  Demodulator nach einem der Ansprüche 1 bis 4, gekennzeichnet durch eine komplexe Mischstufe (MS), die dem Nyquistflankenfilter (CHBFNy) vorgeschaltet ist und deren Mischfrequenz (-fBT) so gewählt ist, daß der Bildträger des komplexwertigen Fernsehsignals bei der Frequenz 0 erscheint.

6.  Demodulator nach einem der Ansprüche 1 bis 4, gekennzeichnet durch eine Mischeinrichtung (FUTT), die dem Nyquistflankenfilter (CHBFNy) nachgeschaltet ist, wobei das Nyquistflankenfilter (CHBFNy) so aufgebaut ist, daß an seinem Ausgang ein komplexwertiges Digitalsignal erscheint, welches der Mischeinrichtung zuführbar ist.

7.  Demodulator nach einem der Ansprüche 4 bis 6, dadurch gekennzeichnet, daß der Dezimationsfaktor des dezimierenden Nyquistflankenfilters (CHBFTNyD) jenem Faktor entspricht, um den das komplexwertige Fernsehsignal bezüglich seiner Nutzbandbreite zuvor überabgetastet wurde.

8.  Demodulator nach einem der Ansprüche 1 bis 7, dadurch gekennzeichnet, daß das Nyquistflankenfilter (CHBFNy) und die Filtereinrichtung (FBASTP) zur Unterdrückung von mindestens einem Tonträger als Kombinationsfilter (CBFTNyTT) ausgebildet ist, wobei in einem Teilfiltr (Ra) für den Realteil eine mit einem vorgegebenen Faktor skalierte Filterstruktur eines Tiefpasses (FBASTP) zur Tonunterdrückung vorgesehen ist und in einem Teilfilter (Ia) für den Imaginärteil ein Hilbert-Transformator (HT) vorgesehen ist, dessen Koeffizienten bis auf den mittleren ungleich Null sind.

9. Demodulator nach Anspruch 6, dadurch gekennzeichnet, daß das komplexwertige Ausgangssignal des Nyquistflankenfilters (CHBFNy) sowohl einer Mischeinrichtung (FUTT) für komplexwertige Signale zur Gewinnung eines Mischsignals für einen FM-Tondemodulator als auch einer Tonfalle (CFBASTP) für komplexwertige Eingangssignale zugeführt ist.

10. Demodulator nach Anspruch 9, dadurch gekennzeichnet, daß die Tonfalle (CFBASTP) so ausgebildet ist, daß sie nur reelle Ausgangssignale abgibt.

11. Demodulator nach Anspruch 10, dadurch gekennzeichnet, daß die Durchlaßkante im unteren Durchlaßbereich der Tonfalle auf die Bildträgerfrequenz (f=0) gelegt ist.

12. Demodulator nach Anspruch 10 oder 11, dadurch gekennzeichnet, daß die Tonfalle (CFBASTP) von einem reellen Halbbandfilter als Prototyp abgeleitet ist.

13. Demodulator nach Anspruch 10 oder 11, dadurch gekennzeichnet, daß die Tonfalle (CFBASTP) von einem reellen Tiefpaß als Prototyp abgeleitet ist.

14. Demodulator nach Anspruch 4 oder 7, dadurch gekennzeichnet, daß für das dezimierende komplexe Nyquistflankenfilter (CHBFTNyD) im Filterzweig für reelle Koeffizienten (Ra) nur der Koeffizient $h_r = 1/2$ vorhanden ist und im Filterzweig für imaginäre Koeffizienten (Ia) nur ein Hilbert-Operator (jhi') vorhanden ist.

15. Demodulator nach den Ansprüchen 5 bis 7, dadurch gekennzeichnet, daß das Nyquistflankenfilter (CHBFNy) nur einen Ausgang für ein reellwertiges Digitalsignal aufweist.

16. Demodulator nach einem der Ansprüche 1 bis 8, dadurch gekennzeichnet, daß die Filtereinrichtung (FBASTP) zur Unterdrückung des/der Tonträger/s als Tonweiche (FBASTPK) ausgebildet ist.

17. Demodulator nach einem der Ansprüche 1 bis 16, dadurch gekennzeichnet, daß ausgangsseitig ein Gruppenlaufzeitentzerrer (FBASENT) vorgesehen ist, der insbesondere aus zwei FIR-Filterblöcken besteht, wobei der eine Block positiv symmetrische und der andere Block negativ symmetrische Koeffizienten aufweist.

Fig. 1

Fig. 2

Fig. 3

Fig. 4

Fig. 6

Fig. 5

Fig.7

Fig. 8

Fig. 9

EP 0 717 493 A2

**Tab. 1**

```
==================================================
I     Liste der komplexen Koeffizienten      I
==================================================
```

| Koef. | Reelle Teile | Imaginaere Teile |
|-------|--------------|------------------|
| 1     |              | -0.119110E-01    |
| 2     |              | 0.000000E+00     |
| 3     |              | -0.226528E-01    |
| 4     |              | 0.000000E+00     |
| 5     |              | -0.453826E-01    |
| 6     |              | 0.000000E+00     |
| 7     |              | -0.942666E-01    |
| 8     |              | 0.000000E+00     |
| 9     |              | -0.314213E+00    |
| 10    | 0.500000E+00 | 0.000000E+00     |
| 11    |              | 0.314213E+00     |
| 12    |              | 0.000000E+00     |
| 13    |              | 0.942666E-01     |
| 14    |              | 0.000000E+00     |
| 15    |              | 0.453826E-01     |
| 16    |              | 0.000000E+00     |
| 17    |              | 0.226528E-01     |
| 18    |              | 0.000000E+00     |
| 19    |              | 0.119110E-01     |

===================================================
I     Liste der komplexen Koeffizienten     I
===================================================

*Tab. 2*

| Koef. | Reelle Teile | Imaginaere Teile |
|-------|--------------|------------------|
| 1 | 0.471917E-03 | 0.000000E+00 |
| 2 | 0.604320E-02 | 0.000000E+00 |
| 3 | -0.116610E-01 | 0.000000E+00 |
| 4 | 0.182580E-01 | 0.000000E+00 |
| 5 | -0.230852E-01 | 0.000000E+00 |
| 6 | 0.249729E-01 | 0.000000E+00 |
| 7 | -0.246945E-01 | 0.000000E+00 |
| 8 | 0.244438E-01 | 0.000000E+00 |
| 9 | -0.260573E-01 | 0.000000E+00 |
| 0 | 0.291383E-01 | 0.000000E+00 |
| 11 | -0.306160E-01 | 0.000000E+00 |
| 12 | 0.264909E-01 | 0.000000E+00 |
| 13 | -0.149334E-01 | 0.000000E+00 |
| 14 | -0.140258E-02 | 0.000000E+00 |
| 15 | 0.158794E-01 | 0.000000E+00 |
| 16 | -0.215101E-01 | 0.000000E+00 |
| 17 | 0.157253E-01 | 0.000000E+00 |
| 18 | -0.295064E-02 | 0.000000E+00 |
| 19 | -0.739308E-02 | 0.000000E+00 |
| 20 | 0.690521E-02 | 0.000000E+00 |
| 21 | 0.535114E-02 | 0.000000E+00 |
| 22 | -0.206458E-01 | 0.000000E+00 |
| 23 | 0.250783E-01 | 0.000000E+00 |
| 24 | -0.903323E-02 | 0.000000E+00 |
| 25 | -0.241253E-01 | 0.000000E+00 |
| 26 | 0.562031E-01 | 0.000000E+00 |
| 27 | -0.618794E-01 | 0.000000E+00 |
| 28 | 0.227379E-01 | 0.000000E+00 |
| 29 | 0.601375E-01 | 0.000000E+00 |
| 30 | -0.162816E+00 | 0.000000E+00 |
| 31 | 0.247569E+00 | 0.000000E+00 |
| 32 | 0.719640E+00 | 0.000000E+00 |
| 33 | 0.247569E+00 | 0.000000E+00 |
| 34 | -0.162816E+00 | 0.000000E+00 |
| 35 | 0.601375E-01 | 0.000000E+00 |
| 36 | 0.227379E-01 | 0.000000E+00 |
| 37 | -0.618794E-01 | 0.000000E+00 |
| 38 | 0.562031E-01 | 0.000000E+00 |
| 39 | -0.241253E-01 | 0.000000E+00 |
| 40 | -0.903323E-02 | 0.000000E+00 |
| 41 | 0.250783E-01 | 0.000000E+00 |
| 42 | -0.206458E-01 | 0.000000E+00 |
| 43 | 0.535114E-02 | 0.000000E+00 |
| 44 | 0.690521E-02 | 0.000000E+00 |
| 45 | -0.739308E-02 | 0.000000E+00 |
| 46 | -0.295064E-02 | 0.000000E+00 |
| 47 | 0.157253E-01 | 0.000000E+00 |
| 48 | -0.215101E-01 | 0.000000E+00 |
| 49 | 0.158794E-01 | 0.000000E+00 |
| 50 | -0.140258E-02 | 0.000000E+00 |
| 51 | -0.149334E-01 | 0.000000E+00 |

Tab. 2 f

| 52 | 0.264909E-01 | 0.000000E+00 |
|----|--------------|--------------|
| 53 | -0.306160E-01 | 0.000000E+00 |
| 54 | 0.291383E-01 | 0.000000E+00 |
| 55 | -0.260573E-01 | 0.000000E+00 |
| 56 | 0.244438E-01 | 0.000000E+00 |
| 57 | -0.246945E-01 | 0.000000E+00 |
| 58 | 0.249729E-01 | 0.000000E+00 |
| 59 | -0.230852E-01 | 0.000000E+00 |
| 60 | 0.182580E-01 | 0.000000E+00 |
| 61 | -0.116610E-01 | 0.000000E+00 |
| 62 | 0.604320E-02 | 0.000000E+00 |
| 63 | 0.471917E-03 | 0.000000E+00 |

Fig. 10

Re

T   T   T   T   ---   T

h1   h2           h63

Fig. 11

$FBAS_{TT}$   CHBF Ny

FBASTPK

FBASENT   FBAS

$-1/2 sin/$
$cos (f_{T1}+f_{T2})$
Tab.

FUTT

FM - Ton demod.

Fig. 12a

Fig. 12b

Fig. 12c

Fig. 13

Fig. 14

Ra ; FBASTP (skal.)

$x_r$ ⟶ | $h_r = \frac{1}{2}$ | ⟶ | FBASTP | ⟶ + ⊕ ⟶ $y_R'$

$j x_i'$ ⟶ | $j' h_i'$ | ⟶ | FBASTP | ⟶ −

Ia ; FBASTP HT

Fig. 15

$FBAS_{TT}$ ⟶ | CHBFTRSB | ⟶ | CFBASTP | ⟶ FBAS

FUTT ⊗ ⟵ | $-\frac{1}{2}(f_{T1} + f_{T2})$ |

↓ | ↓15 | ~ VF

Fig. 16

FM-Tondemod.

Fig. 17

TP Ⅱ

HBF Ⅰ

1/2

$-\frac{1}{4}$  $-fm$   $fm$  1/4  $fsp$  $fsp1$  $fsp2$  $f/fA$

Fig. 18

Re {h(k)}

0,5

-1  1  k

Fig. 19

Im {h(k)}

k

Fig. 20

Fig. 21

Fig. 22

Fig. 23

Fig. 24a

Fig. 24b

Fig. 24c

Fig. 25

Fig. 26

$\tau_g = 0,495 \mu s$